# FASCICULE DE BREVET EUROPEEN

(11) **EP 0 337 235 B1**
(45) Date de publication et mention de la délivrance du brevet: **01.12.1993**
(21) Numéro de dépôt: 89105808.3
(22) Date de dépôt: 03.04.1989
(51) Int. Cl.: G01R 31/00

(54) **Dispositif pour l'essai de relais de protection électrique d'une installation pendant le fonctionnement de celle-ci**
Schutzrelais-Prüfanordnung für die Verwendung während des Betriebs des Relais
Appliance for testing electrical protection relays during operation

(30) Priorité: 11.04.1988 FR 8804771
(43) Date de publication de la demande: 18.10.1989
(73) Titulaire: GEC ALSTHOM SA, 75116 Paris (FR)
(72) Inventeur: Ebersohl, Gérard, F-69350 La Mulatière (FR); Martin, Antonio, F-69007 Lyon (FR); Valancogne, René, F-69002 Lyon (FR)
(74) Mandataire: Weinmiller, Jürgen

(56) Documents cités:
- FR-A- 2 344 947
- US-A- 3 924 178

## Description

L'invention concerne un dispositif pour l'essai d'un ensemble de relais électriques de protection d'une installation pendant le fonctionnement de celle-ci.

Il est connu, par exemple du document FR-A-2344947, un dispositif pour l'essai de relais de protection électrique d'une installation, comportant:
- un circuit d'injection comprenant des moyens pour élaborer des courants de valeurs calibrées et des tensions de valeur donnée,
- une boîte d'injection comprenant un relais d'injection comprenant une bobine actionnant des contacts permettant d'aiguiller et d'injecter un courant calibré d'essai ou une tension d'essai, fournis par le circuit d'injection,
- un circuit séquenceur comprenant un automate programmé pour établir une séquence d'essais prédéterminée,
- un circuit de signalisation signalant le fonctionnement ou le non fonctionnement dudit relais.

Jusqu'à ce jour, la vérification du bon fonctionnement des relais nécessite l'interruption du fonctionnement de l'installation. Un but de l'invention est de réaliser un dispositif permettant de tester un ensemble de relais de protection sans interrompre le fonctionnement de l'installation.

Un autre but de l'invention est de réaliser un dispositif d'essai permettant un essai automatique des divers relais et selon une séquence prédéterminée.

Les relais sont, selon l'invention, essayés unitairement et successivement suivant une séquence prédéterminée. L'essai est du type donnant le résultat : BON - pas BON. Lors de l'essai, le circuit d'utilisation du relais essayé est ouvert pour éviter tout déclenchement intempestif. Un contact travail du relais est réservé pour la signalisation du résultat de l'essai.

L'invention a pour objet un dispositif pour l'essai de relais de protection d'une installation électrique sans interruption du fonctionnement de celle-ci, chacun des relais comprenant au moins une bobine commandant des contacts dont un certain nombre est relié à un circuit d'utilisation comprenant notamment un disjoncteur et/ou un organe de signalisation, et dont un autre est inséré dans un circuit de signalisation signalant le fonctionnement ou le non fonctionnement dudit relais de protection, ce dispositif comportant un circuit séquenceur comprenant un automate programmé pour établir une séquence d'essais prédéterminée, un circuit d'injection comprenant des moyens pour élaborer des courants de valeurs calibrées et des tensions de valeur donnée, et des boîtes d'injection dont chacune est associée à un des relais de protection essayés et comprend un relais d'injection comprenant une bobine alimentée par l'intermédiaire dudit circuit séquenceur et actionnant des contacts permettant d'aiguiller et d'injecter un courant calibré d'essai ou une tension d'essai, fournis par le circuit d'injection, et ce dispositif étant essentiellement caractérisé en ce que chacune desdites boîtes d'injection comporte un relais de verrouillage comprenant une bobine et des contacts en série avec le circuit d'utilisation du relais de protection essayé correspondant, en ce que ledit courant calibré d'essai ou ladite tension d'essai est fourni en parallèle sur l'une ou l'autre des bobines du relais de protection essayé, sans commutation du circuit normal d'excitation de cette bobine, et en ce que les bobines des relais de verrouillage sont alimentées par l'intermédiaire dudit séquenceur.

L'invention sera bien comprise par la description ci-après d'un mode préféré de réalisation de l'invention, en référence au dessin annexé dans lequel
- la figure 1 est un schéma synoptique montrant un ensemble de relais, équipés du dispositif de l'invention;
- la figure 2 est un schéma plus détaillé du circuit d'injection,
- la figure 3 est un schéma du circuit de sécurité équipant la boîte d'injection de tension,
- la figure 4 est un organigramme pour un essai automatique au moyen du dispositif de l'invention.

L'exemple choisi pour illustrer l'invention montre trois relais de protection 10,20 et 30. Bien entendu, l'invention s'applique normalement à la surveillance d'un ensemble pouvant comprendre un beaucoup plus grand nombre de relais, de quelques dizaines à quelques centaines.

Le relais 10 est un relais ampèremétrique biphasé; on a représenté les deux bobines du relais, 11 et 12, (phases φ1 et φ2) reliées respectivement au secondaire de transformateurs de courant 41 et 42 dont les primaires 43 et 44 sont parcourus par les deux phases du courant de l'installation protégée.

Les bobines 11 et 12 actionnent un contracteur ayant des contacts 13, 14 placés en série dans un circuit d'utilisation comprenant bien entendu un organe de coupure, mais aussi divers organes de signalisation, non représentés mais globalement désignés par les lettres ut10.

Le contacteur possède un autre contact 15, qui est utilisé pour signaler le résultat de l'essai à un circuit séquenceur 120 dont le rôle et le fonctionnement seront décrits plus loin.

Le second relais 20 est un autre relais ampèremétrique monophasé, comprenant une bobine 21 reliée au transformateur de courant 41. La bobine 21 actionne des contacts 23 et 24 en série dans le circuit d'utilisation ut20 du relais et un contact 25 relié au circuit séquenceur 120 pour signaler le résultat de l'essai.

Le troisième relais 30 est un relais de tension protégeant par exemple la première phase φ1 de l'utilisation et qui comprend une bobine 31, alimentée par le secondaire d'un transformateur de potentiel 50, dont le primaire reçoit la tension U de l'installation à surveiller. Comme précédemment, la bobine 31 actionne un contacteur ayant deux contacts 33 et 34 d'utilisation ut30 et un contact 35 utilisé par le circuit séquenceur 120 pour indiquer le résultat de l'essai.

L'essai des relais est, comme on l'a déjà indiqué, réalisé en injectant dans la bobine du relais une intensité ou une tension convenable et en déconnectant alors les contacts de sortie de l'utilisation.

Chacun des relais est associé à une boîte d'injection qui assure ces fonctions.

On a désigné par 60, 70 et 80 les boîtes d'injection respectivement associées aux relais 10, 20 et 30.

La boîte d'injection 60 comprend un relais d'injection ayant un bobinage 61 actionnant deux paires de contacts d'injection 62, 63, 64 et 68, en série avec les bobines 11 et 12 et parcourus par des courants de valeur donnée fournis par un circuit d'injection 100 qui sera décrit en détail plus loin. La bobine 61 est alimentée par le circuit séquenceur 120.

La boîte d'injection 60 comprend en outre un second relais, dit relais de verrouillage, ayant une bobine 65 qui actionne des contacts 66 et 67 en série dans le circuit d'utilisation ut10 du relais 10 à essayer.

Les contacts 66 et 67 sont normalement fermés et ne s'ouvrent que lorsque la bobine 65 est alimentée.

La boîte d'injection 70 comprend, de la même manière, un relais d'injection ayant une bobine 71 actionnant des contacts 72 et 73 en série avec la bobine 21 et alimentée par le circuit d'injection 100 ; la boîte d'injection comporte un relais de verrouillage ayant une bobine 75 actionnant des contacts 76 et 77 en série avec le circuit d'utilisation ut20 du relais 20.

La boîte d'injection 80, associée au relais de tension 30 renferme deux résistances 91 et 92, en série dans le circuit du transformateur 50, et dont la valeur est choisie pour que seule la tension injectée fasse fonctionner le relais lors de l'essai.

Les résistances sont par exemple de l'ordre de 1000 ohms.

La boîte d'injection 80 comprend, comme les autres boîtes, un relais d'injection ayant une bobine 81 commandant deux contacts 82 et 83 disposés en série avec la bobine 31 du relais à essayer et branchés au circuit d'injection 100 ; la boîte comporte également un relais de verrouillage ayant une bobine 85 actionnant des contacts 86 et 87 en série dans le circuit d'utilisation ut30 du relais 30. Les bobines 81 et 85 sont alimentées par le circuit séquenceur 120.

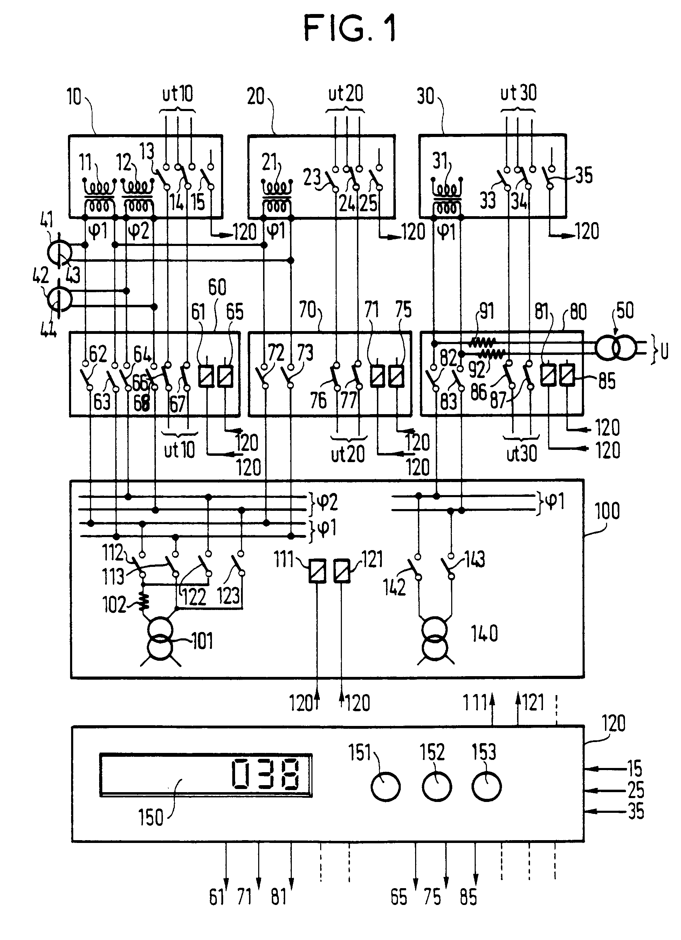

Dans la figure1,on a représenté très partiellement le circuit d'injection puisqu'on n'a fait figurer que les fils d'alimentation des phases utilisées (φ1, φ2), et du calibre utilisé.

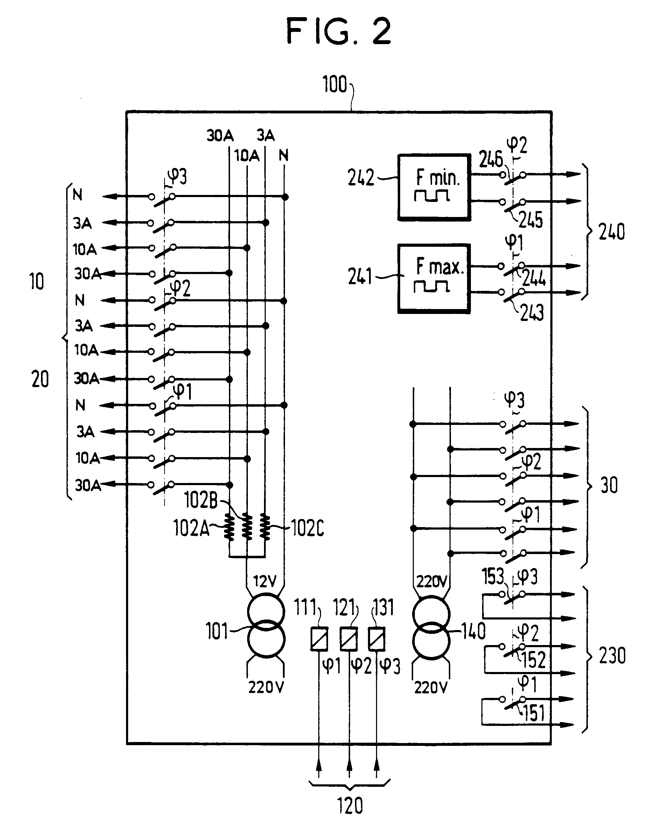

Une représentation plus complète est donnée en référence à la figure 2 sur lequel on reviendra plus loin.

Revenant à la figure 1, on voit que le circuit d'injection comprend un générateur de courant comprenant un transformateur de potentiel 101 (par exemple 220 V alternatif au primaire et 12 V alternatif au secondaire) dont le circuit secondaire est en série avec une résistance 102 fournissant un courant d'intensité donné.

Ce courant est distribué sur l'une des deux phases φ1 et φ2 au moyen de deux relais ayant l'un une bobine 111 actionnant deux contacts 112 et 113 (phase φ1), l'autre une bobine 121 actionnant deux contacts 122 et 123 (phase φ2).

Les bobines 111 et 121 sont alimentées par le circuit séquenceur 120. Le circuit d'injection 100 comprend en outre, pour l'injection de tensions d'essais, un transformateur de potentiel dont le secondaire est muni de contacts 142 et 143 actionnés par la bobine 111, pour distribuer la tension d'essai sur la phase φ1.

Le séquenceur 120 est un automate à logique programmable. Il comprend, sur sa face avant, un afficheur à cristaux liquides 150 et un certain nombre de boutons poussoirs tels que 151, 152 et 153.

En fonction du programme d'essai choisi, le circuit séquenceur adresse des ordres de commande aux bobines 111, 121 des relais du circuit d'injection pour le choix de la phase d'injection ainsi qu'aux bobines 61, 65, 71, 75, 81, 85 des relais d'injection et de verrouillage.

Avant d'expliquer plus en détail une séquence d'essais il est bon de préciser la composition du circuit d'injection 100.

Ce dernier est représenté plus en détail dans la figure 2.

On voit que l'injection de courant par le transformateur 101 autorise, grâce à plusieurs résistances au secondaire 102A, 102B, 102C, plusieurs calibres de courant (par exemple 3 ampères, 10 ampères, 30 ampères) qui sont distribués sur les 3 phases par les relais de bobines 111, 121, 131.

De même, l'injection de tension par le transformateur de potentiel s'effectue sur les trois phases.

Le relais 111, 121, 131 peut également commander un jeu de contacts 151, 152, 153 pour la mise en court-circuit des bobines d'un relais 230, non représenté, à minimum de tension.

Le circuit d'injection peut comporter également des générateurs de créneaux de tension, tel que le générateur 241 générant un créneau de tension plus ou moins 24 volts à une fréquence fn + 10Hz (fn : fréquence du circuit d'alimentation de l'installation) et le générateur 242 générant des créneaux de fréquence fn - 10Hz.

Ces générateurs alimentent l'une (φ1) ou l'autre (φ2) des phases d'un relais de fréquence 240 non représenté, par l'intermédiaire de contacteurs 243, 244, 245, 246 commandés par les bobines 111 et 121.

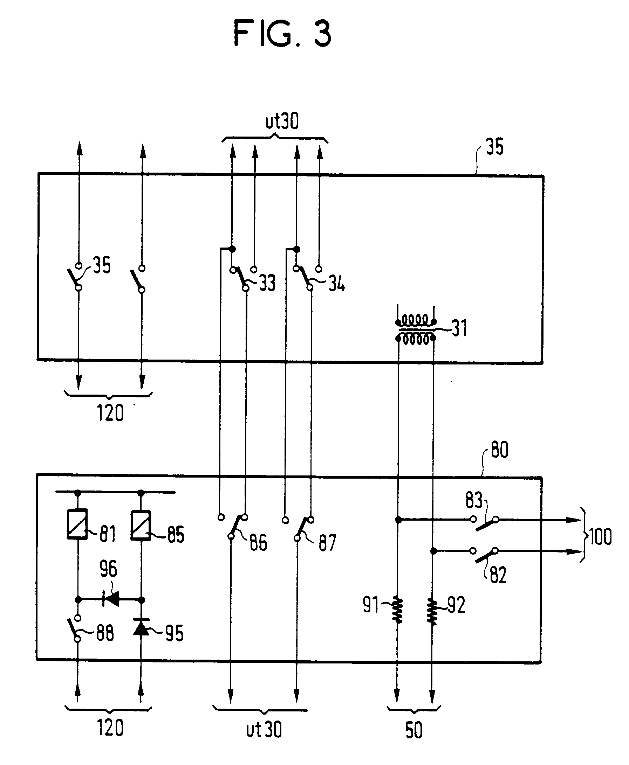

La figure 3 montre comment la sécurité est assurée dans la boîte d'injection pour éviter que la tension d'injection soit injectée si le verrouillage du relais de déconnexion de l'utilisation n'est pas assuré.

Comme le montre la figure 3, le relais d'injection 81 est alimenté en parallèle avec le relais de verrouillage 85.

Un contact 88, commandé par le relais de verrouillage 85 est en série avec la bobine 81.

Une diode 95 est branchée dans le circuit d'alimentation de la bobine 85, et une diode 96 est en parallèle sur les bobines 81 et 85.

Le fonctionnement est le suivant : pour effectuer un essai du relais 31 par injection d'une tension d'essai fournie par le circuit d'injection, on excite le relais de verrouillage 85 (par le séquenceur 120) ; la bobine 85 ferme alors les contacts 86 et 87, ce qui déconnecte le circuit d'utilisation ut30 du relais 31, ainsi que le contact 88.

Le relais 81 est alors excité, ce qui ferme les contacts 82 et 83 et permet l'injection de la tension d'essai.

Tant que le relais 81 est excité, la bobine V est alimentée par le circuit 81, 85, 96 ce qui assure le maintien du verrouillage et de la mise hors circuit de l'utilisation ut30.

Le relais de verrouillage est temporisé à la disparition de l'excitation (temporisation supérieure à une seconde).

La sécurité est bien assurée puisque le relais d'injection ne peut fonctionner que s'il y a verrouillage.

Comme il a été déjà indiqué, le séquenceur 120 est un automate comportant des mémoires mortes dans lesquelles sont définis les différents types d'essais à effectuer.

Le séquenceur est chargé des fonctions suivantes :
- détermination du moment adéquat pour tester un relais,
- vérification du non fonctionnement sur défaut du relais concerné,
- mise en route de la séquence de verrouillage du relais (déconnexion de l'utilisation),
- mise en route de l'injection des grandeurs de mesure (courant ou tension),
- vérification de la bonne réponse du relais,
- suppression de l'injection des grandeurs de mesure (courant ou tention),
- vérification du retour à l'état de repos des contacts du relais de protection,
- suppression du verrouillage.

Si le relais est déclaré mauvais, le verrouillage persiste. Il ne peut être supprimé que par une commande locale.
- passage à la séquence suivante.
   Les temps qui séparent les différentes phases d'une séquence sont liés au relais de protection testé.
   Le séquenceur comporte :
- une logique de sécurité,
- trois relais de signalisation :
   . défaut automate,
   . boucle de verrouillage (au moins un relais est verrouillé),
   . relais déclarés bons (tous les relais testés sont bons).
   La logique de sécurité est chargée de surveiller le séquenceur. Elle est constituée de deux "watch-dogs" :
   . un watch-dog rapide (20ms) de contrôle du logiciel,
   . un watch-dog long (plusieurs dizaines de secondes) de contrôle de la durée de test de chaque relais de protection.
   Si l'une des temporisations des "watch-dogs" arrive à échéance, le relais alarme est excité et les injections supprimées.
   Le logiciel assure par ailleurs la surveillance de l'automate :
   . "check sum" des mémoires mortes (ROM),
   . "check sum" des mémoires vives (RAM),
   . contrôle de passage du logiciel par les différentes phases.
   Dans ce cas également le relais alarme est excité.
   La mise en service du système d'essai automatique conduit, par un dialogue, à programmer :
- L'automate :
   . mise EN ou HORS service,
   . Lancement de l'essai de tous les relais à essayer en local manuellement ou à distance par contact, ou en local automatiquement grâce à une horloge interne programmable de 1 à 999 heure,
- Les relais :
   . choix des relais à essayer,
   . essai manuel unitaire (avec l'automate en service ou non),
   . déverrouillage local d'un relais après détection du défaut et remplacement,
- La lecture des fichiers :
   . relais déclarés bons,
   . relais retenus pour l'essai,
   . relais hors essai.
- une remise à zéro générale, qui remet le système en l'état initial :
   . suppression de tous les verrouillages,
   . mise hors service de l'automate (le choix des relais retenus pour l'essai est conservé).
   Pour cette programmation on dispose :
- d'un afficheur à cristaux liquides 150,
- d'un bouton poussoir FONCTION 152 pour le défilement du programme
- d'un bouton poussoir ACQUIT 153 pour la validation de la fonction affichée.
   Par ailleurs, un bouton poussoir de remise à zéro générale 151 permet la réinitialisation du système :
- suppression de tous les verrouillages,
- mise hors service de l'automate.
   L'utilisation de ce bouton poussoir fait disparaître le choix des relais retenue pour l'essai.

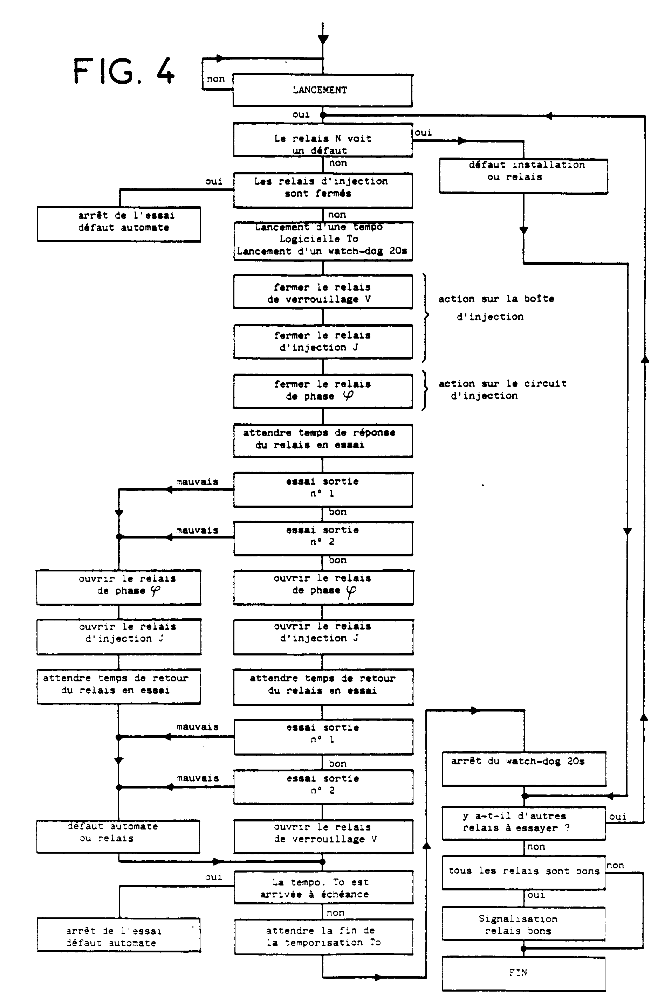

Un exemple d'organigramme de programme automatique d'essai est donné dans la figure 4.

## Revendications

1. Dispositif pour l'essai de relais de protection (10, 20, 30) d'une installation électrique sans interruption du fonctionnement de celle-ci, chacun des relais comprenant au moins une bobine (11, 12) commandant des contacts (13, 14, 15) dont un certain nombre (13, 14) est relié à un circuit d'utilisation (ut10) comprenant notamment un disjoncteur et/ou un organe de signalisation et dont un autre (15) est inséré dans un circuit de signalisation signalant le fonctionnement ou le non-fonctionnement dudit relais de protection, dispositif comportant un circuit séquenceur (120) comprenant un automate programmé pour établir une séquence d'essais prédéterminée, un circuit d'injection (100) comprenant des moyens pour élaborer des courants de valeurs calibrées et des tensions de valeur donnée, et des boîtes d'injection (60, 70, 80) dont chacune est associée à un des relais de protection essayés et comprend un relais d'injection comprenant une bobine (61, 71, 81) alimentée par l'intermédiare dudit circuit séquenceur et actionnant des contacts (62, 63, 64, 68; 72, 73; 82, 83) permettant d'aiguiller et d'injecter un courant calibré d'essai ou une tension d'essai, fournis par le circuit d'injection (100), caractérisé en ce que chacune desdites boîtes d'injection comporte un relais de verrouillage comprenant une bobine (65, 75, 85) et des contacts (66, 67; 76, 77; 86, 87) en série avec le circuit d'utilisation du relais de protection essayé correspondant, en ce que ledit courant calibré d'essai ou ladite tension d' essai est fourni en parallèle sur l'une ou l'autre des bobines du relais de protection essayé, sans commutation du circuit normal d'excitation de cette bobine, et en ce que les bobines (65; 75, 85) des relais de verrouillage sont alimentées par l'intermédiaire dudit séquenceur (120).

2. Dispositif selon la revendication 1, caractérisé par le fait que, dans une desdites boîtes d'injection (60, 70, 80) injectant une tension d'essai, la bobine (85) du relais de verrouillage est alimentée par la bobine (81) du relais d'injection pendant toute la durée de fermeture dudit relais d'injection.

3. Dispositif selon l'une des revendications 1 et 2, caractérisé en ce que le circuit d'injection (100) comporte deux circuits (241, 242) élaborant respectivement des créneaux de tension à une fréquence égale à celle d'un circuit d'alimentation de l'installation augmentée d'une quantité donnée et des créneaux à une fréquence égale à celle dudit circuit d'alimentation de l'installation diminuée de ladite quantité donnée.

## Claims

1. Device for testing relays (10, 20, 30) protecting an electrical installation without interrupting operation of the installation, each relay comprising at least one coil (11, 12) controlling contacts (13, 14, 15) some of which (13, 14) are connected to a load circuit (ut10) including a circuit-breaker and/or a signalling unit and others of which (15) are connected into a signalling circuit for signalling operation or non-operation of said protection relay, said device comprising a sequencer circuit (120) comprising a programmable automatic controller for establishing a predetermined test sequence, an injector circuit (100) comprising means for producing calibrated currents and voltages of given value, and injector boxes (60, 70, 80) each of which is associated with one of the protection relays under test and comprises an injector relay comprising a coil (61, 71, 81) energised by said sequencer circuit and operating contacts (62, 63, 64, 68; 72, 73; 82, 83) for switching and injecting a calibrated test current or a test voltage supplied by the injector circuit (100), characterised in that each injector box comprises a latching relay comprising a coil (65, 75, 85) and contacts (66, 67; 76, 77; 86, 87) in series with the load circuit of the respective protection relay under test, in that said calibrated test current or said test voltage is applied in parallel to one or other of the coils of the protection relay under test without switching the usual excitation circuit of said coil, and in that the coils (65, 75, 85) of the latching relays are energized by said sequencer (120).

2. Device according to claim 1 characterised in that in one of said injector boxes (60, 70, 80) for injecting a test voltage the coil (85) of the latching relay is energized by the coil (81) of the injector relay for as long as said injector relay is operated.

3. Device according to claim 1 or claim 2 characterised in that the injector circuit (100) comprises two circuits (241, 242) respectively producing voltage pulses at a frequency equal to that of an installation power supply circuit increased by a given amount and at a frequency equal to that of said installation power supply circuit decreased by said given amount.

## Patentansprüche

1. Prüfvorrichtung für Schutzrelais (10, 20, 30) einer elektrischen Anlage, wobei die Prüfung ohne Betriebsunterbrechung der Anlage erfolgt und jedes Relais mindestens eine Spule (11, 12) und von ihr gesteuerte Kontakte (13, 14, 15) enthält, von denen einige (13, 14) mit einem Nutzkreis (ut10) verbunden sind, der insbesondere einen Trennschalter und/oder ein Meldeorgan aufweist, während ein anderer Kontakt (15) in einen Meldekreis eingefügt ist, der den korrekten Betrieb des Schutzrelais anzeigt, wobei die Vorrichtung weiter eine Folgeschaltung (120) mit einem programmierte Automaten, um eine vorgegebene Prüfsequenz zu erstellen, eine Einspeiseschaltung (100) mit Mitteln, um kalibrierte Stromwerte und Spannungen eines gegebenen Werts zu erzeugen, und Einspeiseboxen (60, 70, 80) enthält, die je einem der getesteten Schutzrelais zugeordnet sind und je ein Einspeiserelais mit einer Spule (61, 71, 81) enthalten, die durch die Folgeschaltung gespeist wird und Kontakte (62, 63, 64, 68; 72, 73; 82, 83) betätigt, über die ein kalibrierter Prüfstrom oder eine Prüfspannung eingespeist werden kann, der bzw. die von der Einspeiseschaltung (100) geliefert wird, dadurch gekennzeichnet, daß jede der Einspeiseboxen ein Verriegelungsrelais mit einer Spule (65, 75, 85) und Kontakten (66, 67; 76, 77; 86, 87) in Reihe mit den Nutzkreis des entsprechenden gepüften Schutzrelais enthält, daß der kalibrierte Prüfstrom oder die Prüfspannung parallel an die eine oder andere der Spulen des geprüften Schutzrelais ohne Schaltung des normalen Erregungskreises dieser Spule geliefert wird und daß diese Spulen (65, 75, 85) der Verriegelungsrelais durch die Folgeschaltung (120) gespeist werden.

2. Vorrichtung nach Anspruch 1, dadurch gekennzeichnet, daß in einer der Einspeiseboxen (60, 70, 80), die eine Prüfspannung einspeist, die Spule (85) des Verriegelungsrelais von der Spule (81) des Einspeiserelais während der ganzen Zeit gespeist wird, während der das Einspeiserelais geschlossen ist.

3. Vorrichtung nach einem der Ansprüche 1 und 2, dadurch gekennzeichnet, daß die Einspeiseschaltung (100) zwei Schaltungen (241, 242) enthält, die Rechteckspannungsimpulse mit einer Frequenz gleich der einer Speiseschaltung der Anlage plus einem gegebenen Wert sowie Rechteckimpulse einer Frequenz gleich der dieser Speiseschaltung der Anlage minus dem gegebenen Wert erzeugt.
